# EUROPEAN PATENT APPLICATION

(11) **EP 4 787 428 A1**
(43) Date of publication of application: **05.08.2026**
(21) Application number: 24871924.7
(22) Date of filing: 13.09.2024
(51) Int. Cl.: H01L 21/304, B24B 37/00, C09G 1/02, C09K 3/14

(54) **POLISHING COMPOSITION AND POLISHING METHOD**

(30) Priority: 25.09.2023 JP 2023161704
(71) Applicant: Fujimi Incorporated, Kiyosu-shi, Aichi 452-8502 (JP)
(72) Inventor: MOMOTA, Satoshi, Kiyosu-shi, Aichi 452-8502 (JP); ICHITSUBO, Taiki, Kiyosu-shi, Aichi 452-8502 (JP)
(74) Representative: Grünecker Patent- und Rechtsanwälte PartG mbB
(86) International application number: PCT/JP2024/032910
(87) International publication number: WO 2025/070129

(57) **Abstract**

Provided is a polishing composition that is used in polishing a silicon material surface and capable of providing good wettability to the polished surface with reduced defects. The polishing composition comprises an abrasive (A), a basic compound (B), a random copolymer comprising a vinyl alcohol unit and an N-vinylpyrrolidone unit, and a nonionic surfactant. The nonionic surfactant has a molecular weight of below 3000. The nonionic surfactant content α (% by weight) is within the range of 0.00035 < α < 0.00500.

## Description

### [Technical Field]

The present invention relates to a polishing composition and a polishing method.

This application claims priority to Japanese Patent Application No. 2023-161704, filed on September 25, 2023; and the entire content thereof is herein incorporated by reference.

### [Background Art]

Precision polishing is performed on the surfaces of materials such as metals, semimetals, nonmetals and their oxides, using polishing compositions. For example, the surface of a silicon wafer used as a component of a semiconductor device is generally finished to a high-quality mirror surface through a lapping step (rough polishing step) and a polishing step (precision polishing step). The polishing step typically includes a stock polishing step and a final polishing step. Patent Documents 1 to 3 are exemplary technical references of a polishing composition mainly used for polishing semiconductor substrates such as silicon wafers.

### [Citation List]

### [Patent Literature]

[Patent Document 1] Japanese Patent No. 7104053
[Patent Document 2] Japanese Patent No. 6801964
[Patent Document 3] Japanese Patent No. 7050684

### [Summary of Invention]

### [Technical Problem]

Polishing compositions used for polishing semiconductor substrates such as silicon wafers (e.g., polishing compositions used in the final polishing step, especially the final polishing step of semiconductor substrates such as silicon wafers and other substrates) are required to have the ability to achieve a surface with low haze and few surface defects after polishing. For instance, when substrates are properly protected by a water-soluble polymer in the polishing composition, it is possible to improve surface quality after polishing, such as haze value reduction. On the other hand, if residues of the water-soluble polymers are present on the polished substrate surface, they may increase defects (e.g., LPD-N (light point defects non-cleanable)) in the substrate surface inspection. Thus, when polishing with a water-soluble-polymer-containing polishing composition, it is necessary to improve the surface quality by reducing defects (e.g., LPD-N) on the polished substrate surface. For instance, Patent Documents 1 to 3 describe a polishing composition that includes colloidal silica, ammonia and a random copolymer of vinyl alcohol and N-vinylpyrrolidone, along with LPD-N evaluation after polishing with the polishing composition.

To obtain a high-quality surface, it is preferable that the polished silicon wafer surface has sufficient wettability. By keeping the polished surface wet with water (with water film), it is possible to prevent direct deposition of airborne foreign matter on the polished surface. A silicon wafer with such a surface is more likely to have a high-quality surface after cleaning.

The present invention has been created in view of these circumstances with an objective to provide a polishing composition for use in polishing a surface formed of a silicon material and capable of providing good wettability to the polished surface with reduced defects, and also a polishing method using the polishing composition.

### [Solution to Problem]

The present description provides a polishing composition used in polishing a surface formed of a silicon material (or a silicon material surface). The polishing composition includes an abrasive, a basic compound, a random copolymer comprising a vinyl alcohol unit and an N-vinylpyrrolidone unit (or VA-VP random copolymer), and a nonionic surfactant. The nonionic surfactant has a molecular weight of below 3000. The nonionic surfactant is contained in the polishing composition in an amount α (% by weight (wt%)) in the range of 0.00035 < α < 0.00500. According to the polishing composition that includes an abrasive, a basic compound, a VA-VP random copolymer, and a nonionic surfactant with molecular weight below 3000 in an amount within the range of α, the polished silicon material surface has good wettability with reduced surface defects.

In some embodiments, the weight ratio of the nonionic surfactant content to the VA-VP random copolymer content is 0.01 or higher and 2.0 or lower. In an embodiment using a nonionic surfactant and a random copolymer at such a ratio, the effects of the art disclosed herein can be preferably obtained.

In some embodiments, the polishing composition includes silica particles as the abrasive. The polishing composition including silica particles as the abrasive helps obtain a polished surface with good surface quality.

The polishing composition disclosed herein may be a concentrated liquid. The polishing composition disclosed herein may be produced, distributed, and stored in a concentrated liquid form.

In some embodiments, a polishing method is provided, the method including a step of polishing a surface formed of a silicon material, using the polishing composition. According to the polishing method, the polished silicon material surface can have good wettability with reduced surface defects.

### [Description of Embodiments]

Preferred embodiments of the present invention will be described below. Matters other than those particularly mentioned herein but are necessary for implementation of the present invention can be understood as design matters for those skilled in the art based on related technologies in the pertaining field. The present invention can be implemented based on the contents disclosed herein and common technical knowledge in the field.

### <Abrasive (A)>

The polishing composition disclosed herein includes an abrasive. The abrasive contributes to an increase in polishing removal rate by mechanically polishing the surface of an object to be polished. The abrasive is not particularly limited in material, properties, etc., and can be appropriately selected according to the purpose and the way of using the polishing composition. Examples of the abrasive include inorganic particles, organic particles, and organic-inorganic composite particles. Specific examples of inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles and boron nitride particles; carbide particles such as silicon carbide particles and boron carbide particles; diamond particles; and carbonates such as calcium carbonate and barium carbonate. Specific examples of organic particles include polymethylmethacrylate (PMMA) particles, poly(meth)acrylic acid particles (in which (meth)acrylic acid comprehensively refers to acrylic acid and methacrylic acid), and polyacrylonitrile particles. These abrasives can be used singly or in combination of two or more kinds.

As the abrasive, inorganic particles (in particular, particles formed of a metal or semimetal oxide) are preferable, and silica particles are especially preferable. In the polishing composition that can be used in polishing (e.g., final polishing) of objects having a silicon surface, such as silicon wafers, it is particularly beneficial to employ silica particles as the abrasive. For instance, the art disclosed herein can be preferably implemented in an embodiment using essentially only silica particles as the abrasive. From such a viewpoint, the amount of silica particles in the total amount of abrasive is suitably 90 % by weight (wt%) or greater, preferably 95 wt% or greater, more preferably 98 wt% or greater (e.g., 99 wt% to 100 wt%).

Specific examples of the silica particles include colloidal silica, fumed silica, and precipitated silica. The silica particles can be used singly or in combination of two or more kinds thereof. Colloidal silica is particularly preferable because it helps obtain a polished surface with a good surface grade after polishing. Examples of the colloidal silica include colloidal silica prepared by ion exchange starting from water glass (sodium silicate) and alkoxide colloidal silica (colloidal silica produced by the hydrolysis and condensation reaction of alkoxysilane). As the colloidal silica, solely one kind or a combination of two or more kinds can be used.

The silica particles are preferably formed of a silica having an absolute specific gravity of 1.5 or greater, more preferably 1.6 or greater, even more preferably 1.7 or greater. The maximum absolute specific gravity of the silica is not particularly limited. It is typically 2.3 or less, for instance, 2.2 or less. The absolute specific gravity of the silica particles can be a measurement value determined by a liquid substitution method using ethanol as the substitution liquid.

The average primary particle diameter of the abrasive (typically, silica particles, suitably colloidal silica) is not particularly limited. In view of the polishing removal rate, etc., it is preferably 5 nm or greater, more preferably 10 nm or greater. In view of obtaining good polishing results (e.g., haze reduction, defect removal, etc.), the average primary particle diameter is preferably 15 nm or greater, or more preferably 20 nm or greater (e.g., greater than 20 nm). In view of low scratches and the like, the average primary particle diameter of the abrasive is preferably 100 nm or less, more preferably 50 nm or less, even more preferably 45 nm or less. In view of helping to obtain a surface with lower haze, in some embodiments, the average primary particle diameter of the abrasive is preferably 43 nm or less, or may be less than 40 nm, less than 38 nm, less than 35 nm, less than 32 nm, or less than 30 nm.

As used herein, the average primary particle diameter refers to the particle size (BET particle size) calculated from the specific surface area (BET value) determined by the BET method according to the formula: average primary particle diameter (nm) = 6000/(true density (g/cm³) × BET value (m²/g)). The specific surface area can be measured using, for instance, a surface area analyzer, product name FLOWSORB II 2300 available from Micromeritics Instrument Corporation.

The average secondary particle diameter of the abrasive (typically, silica particles) is not particularly limited. For instance, it can be appropriately selected in the range of about 15 nm to 300 nm. In view of increasing the polishing removal rate, the average secondary particle diameter is preferably 30 nm or greater, or more preferably 35 nm or greater. In some embodiments, the average secondary particle diameter may be, for instance, 40 nm or greater, 42 nm or greater, or preferably 44 nm or greater. In typical, the average secondary particle diameter may be 250 nm or less, preferably 200 nm or less, or more preferably 150 nm or less. In some preferred embodiments, the average secondary particle diameter is 120 nm or less, more preferably 100 nm or less, or even more preferably 70 nm or less, or may be, for instance, 60 nm or less, or 50 nm or less.

As used herein, the average secondary particle diameter refers to the particle diameter (volume average particle diameter) determined by dynamic light scattering. For instance, the average secondary particle diameter of the abrasive can be determined by dynamic light scattering, using product name NANOTRAC UPA-UT151 available from Nikkiso Co., Ltd.

The shape (outer shape) of the abrasive (typically, silica particles) may be globular or non-globular. Specific examples of non-globular particles include peanut-shaped (i.e., peanut shell-shaped), cocoon-shaped, conpeito-shaped and rugby ball-shaped particles. For instance, it is preferable to use silica particles that are mostly peanut-shaped or cocoon-shaped.

While no particular limitations are imposed, the average length/width ratio (average aspect ratio) of the abrasive (typically, silica particles) is theoretically 1.0 or higher, preferably 1.05 or higher, more preferably 1.1 or higher, or may be 1.2 or higher. With increasing average aspect ratio, a higher polishing removal rate can be obtained. In view of reducing scratches, etc., the average aspect ratio of the abrasive (typically, silica particles) is preferably 3.0 or lower, more preferably 2.0 or lower, even more preferably 1.5 or lower, or may be 1.4 or lower.

The shape (outer shape) and average aspect ratio of the abrasive (typically, silica particles) can be obtained, for instance, by electron microscopy. For instance, in a particular procedure for determining the average aspect ratio, a scanning electron microscope (SEM) is used to draw the smallest rectangle circumscribing each particle image for a prescribed number (e.g., 200) of abrasive grains (polisher particles, typically silica particles) whose individual particle shapes can be recognized. Then, for the rectangle drawn for each particle image, the long side length (long diameter value) is divided by the short side length (short diameter value) to determine the length/width ratio (aspect ratio). The average aspect ratio can be obtained by taking the arithmetic average of the aspect ratios of the prescribed number of particles.

### <Basic Compound (B)>

The polishing composition disclosed herein includes a basic compound. As used herein, the term basic compound refers to a compound that dissolves in water and increases the pH of the aqueous solution. With the basic compound in the polishing composition, by its chemical polishing action (alkali etching), the object to be polished can be efficiently polished. Possible basic compounds include nitrogen-containing (N-containing) organic or inorganic basic compounds, phosphorous-containing (P-containing) basic compounds, hydroxides of alkali metals, hydroxides of alkaline earth metals, and various carbonates or hydrogen carbonates. Examples of the N-containing basic compounds include quaternary ammonium compounds, ammonia and amines (preferably, water-soluble amines). Examples of the P-containing basic compounds include quaternary phosphonium compounds. These basic compounds can be used singly or in combination of two or more kinds thereof.

Specific examples of the hydroxides of alkali metals include potassium hydroxide and sodium hydroxide. Specific examples of the carbonate salts and hydrogen carbonate salts include ammonium hydrogen carbonate, ammonium carbonate, potassium hydrogen carbonate, potassium carbonate, sodium hydrogen carbonate, and sodium carbonate. Specific examples of the amines include, methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, piperazine anhydride, piperazine hexahydrate, 1-(2-aminoethyl) piperazine, N-methylpiperazine, guanidine, and azoles such as imidazole and triazole. Specific examples of the quaternary phosphonium compounds include quaternary phosphonium hydroxides such as tetramethylphosphonium hydroxide and tetraethylphosphonium hydroxide.

As the quaternary ammonium compound, quaternary ammonium salts (typically, strong bases) such as tetraalkyl ammonium salts and hydroxyalkyl trialkyl ammonium salts can be used. Examples of the anion in such a quaternary ammonium salt include OH⁻, F⁻, Cl⁻, Br⁻, I⁻, ClO₄⁻, and BH₄⁻. Examples of the quaternary ammonium compound include quaternary ammonium salts having OH⁻ as the anion, namely, quaternary ammonium hydroxides. Specific examples of the quaternary ammonium hydroxides include tetraalkyl ammonium hydroxides such as tetramethylammonium hydroxide, tetraethylammonium hydroxide, tetrapropylammonium hydroxide, tetrabutylammonium hydroxide, tetrapentylammonium hydroxide, and tetrahexylammonium hydroxide; and hydroxyalkyl trialkylammonium hydroxides such as 2-hydroxyethyltrimethylammonium hydroxide (or choline).

Among these basic compounds, at least one kind of basic compound selected from hydroxides of alkali metal, quaternized ammonium hydroxide, or ammonia can be preferably used, for example. In particular, more preferred are tetraalkyl ammonium hydroxide (e.g., tetramethyl ammonium hydroxide) or ammonia, and particularly preferred is ammonia.

### <VA-VP Random Copolymer (C)>

The polishing composition disclosed herein includes a random copolymer that includes a vinyl alcohol unit (or "VA unit" hereinafter) and an N-vinylpyrrolidone unit (or "VP unit" hereinafter), namely, a VA-VP random copolymer. Here, in one molecule of the random copolymer, the VA unit is a structural unit (repeating unit) represented by the next chemical formula -CH₂-CH(OH)-. The VA unit can be obtained, for instance, by hydrolysis (saponification) of a structural unit formed by vinyl polymerization of a vinyl ester monomer such as vinyl acetate. In one molecule of the random copolymer, the VP unit is a structural unit derived from N-vinylpyrrolidone as a monomer. The VA-VP random copolymer can be obtained, for instance, by partial or complete saponification of a copolymer of vinyl acetate and N-vinylpyrrolidone. With the use of the VA-VP random copolymer having such a chemical structure, while favorably protecting the surface being polished, the polished surface can have good wettability. By using the VA-VP random copolymer along with the undermentioned low molecular weight nonionic surfactant in the prescribed amount, the polished surface can have good wettability with reduced surface defects. As the VA-VP random copolymer, it is possible to use solely one kind or a combination of two or more kinds varying in molar ratio of VA units and VP units or varying in Mw. Besides VA and VP units, the VA-VP random copolymer may include other structural units (or "non-VA/VP units") as long as not significantly impairing the function of the copolymer or the effects of the invention; or it may be essentially free of non-VA/VP units.

The VA unit to VP unit molar ratio (VA/VP) in the VA-VP random copolymer is not particularly limited. The molar ratio (VA/VP) can be set in a suitable range in which the random copolymer is effective. In some embodiments, the molar ratio (VA/VP) can be, for instance, 50/50 or higher, 65/35 or higher, 70/30 or higher, 75/25 or higher, 80/20 or higher, 85/15 or higher, or 90/10 or higher (e.g., above 90/10). In some embodiments, the molar ratio (VA/VP) can be, for instance, 99/1 or lower, 98/2 or lower, 97/3 or lower, 95/5 or lower, or 93/7 or lower.

The weight-average molecular weight (Mw) of the VA-VP random copolymer is not particularly limited. Whether having a low or high molecular weight, a random copolymer having VA units and VP units can provide sufficient wettability. While no particular limitations are imposed, in some embodiments, the VA-VP random copolymer may have a Mw of, for instance, 100×10⁴ or lower, or suitably 60×10⁴ or lower. In view of concentration efficiency, etc., in some preferable embodiments, the Mw is 30×10⁴ or lower, or may be, for instance, 20×10⁴ or lower, 10×10⁴ or lower, 8×10⁴ or lower, 5×10⁴ or lower, or 3×10⁴ or lower. The lower the Mw is, the higher the dispersion stability of the VA-VP random copolymer tends to be. The Mw can be 2×10⁴ or lower, 1.8×10⁴ or lower, or 1.5×10⁴ or lower (e.g., below 1.5×10⁴). In view of enhancing the wettability after polishing while favorably protecting the surface being polished, in some embodiments, the Mw can be, for instance, 0.2×10⁴ or higher, 0.25×10⁴, 0.3×10⁴ or higher, 0.5×10⁴ or higher, or 0.8×10⁴ or higher. As the Mw of the VA-VP random copolymer increases, the effect to enhance the protection of the object to be polished tends to increase. From such a viewpoint, in some preferable embodiments, the Mw is 1.0×10⁴ or higher (e.g., above 1.0×10⁴), or may be 1.5×10⁴ or higher, 1.8×10⁴ or higher, 2.0×10⁴ or higher (e.g., above 2.0×10⁴), 2.3×10⁴ or higher, 2.5×10⁴ or higher, or 2.8×10⁴ or higher.

The Mw of a water-soluble polymer can be calculated from a value based on aqueous-phase gel permeation chromatography (GPC) (aqueous phase, based on standard polyethylene oxides). The same applies to the Mw values of the VA-VP random copolymer and undermentioned optional water-soluble polymers. As the GPC system, model name HLC-8320 GPC available from Tosoh Corporation can be used. The analysis conditions can be as follows. The same method is also employed in the working examples described later.

### [GPC Analysis Conditions]

Sample concentration: 0.1 wt%
Column: TSKgel GMPW_{XL}
Detector: differential refractometer
Eluent: 100 mM aqueous NaNO₃ solution
Flow rate: 1 mL/min
Measurement temperature: 40 °C
Injection volume: 200 µL

While no particular limitations are imposed, in some embodiments, the amount of the VA-VP random copolymer in the polishing composition can be, for instance, 0.01 part by weight or greater per 100 parts by weight of abrasive (typically silica particles). In view of improving the wettability, etc., it is suitably 0.1 part by weight or greater, preferably 0.5 part by weight or greater, more preferably 1 part by weight or greater, or may be 1.5 parts by weight or greater, or 2 parts by weight or greater. The amount of the VA-VP random copolymer per 100 parts by weight of abrasive can be, for instance, 50 parts by weight or less, or 30 parts by weight or less. In view of dispersion stability of the polishing composition, etc., in some embodiments, the amount of the VA-VP random copolymer per 100 parts by weight of abrasive is suitably 15 parts by weight or less, preferably 10 parts by weight or less, and more preferably 5 parts by weight or less, and may be 3 parts by weight or less, or 2.5 parts by weight or less. By using the VA-VP random copolymer in an amount suitably set within these ranges, while protecting the surface being polished, the polished surface can have good wettability.

While no particular limitations are imposed, in some embodiments, the weight ratio (B/C) of the basic compound content (B) to the VA-VP random copolymer content (C) in the polishing composition can be, for instance, 0.01 or higher. In view of the polishing removal rate, etc., it is suitably 0.1 or higher, preferably 0.5 or higher, more preferably 1.0 or higher, yet more preferably 2.0 or higher, or may be 2.5 or higher. In some embodiments, the weight ratio (B/C) can be, for instance, 15 or lower, or 10 or lower. In view of preferably protecting the surface being polished to maintain or improve the surface quality, the weight ratio (B/C) is suitably 7 or lower, preferably 5 or lower, and more preferably 4 or lower. By suitably setting the VA-VP random copolymer content and the basic compound content so that the ratio (B/C) falls within the above ranges, high surface quality can be obtained.

### <Nonionic Surfactant (D) with Molecular Weight Below 3000>

The polishing composition disclosed herein includes a nonionic surfactant having a molecular weight (mw) of below 3000. With the VA-VP random copolymer content and the further inclusion of nonionic surfactant with molecular weight below 3000 within a suitable concentration range, the surface to be polished can be favorably protected resulting in defect reduction while the polished surface can have good wettability. The inclusion of the nonionic surfactant can further reduce haze on the polished surface. It is also preferred to use a nonionic surfactant in view of low foaming and ease of pH adjustment. Examples of the nonionic surfactant include oxyalkylene polymers such as polyethylene glycol, polypropylene glycol, and polytetramethylene glycol; polyoxyalkylene derivatives (e.g., polyoxyalkylene adducts) such as polyoxyethylene alkyl ether, polyoxyethylene alkyl phenyl ether, polyoxyethylene alkyl amine, polyoxyethylene fatty acid ester, polyoxyethylene glyceryl ether fatty acid ester, and polyoxyethylene sorbitan fatty acid ester; and copolymers of several kinds of oxyalkylene (e.g., diblock copolymers, triblock copolymers, random copolymers, and alternating copolymers). As the nonionic surfactant, solely one kind or a combination of two or more kinds can be used.

Specific examples of the nonionic surfactant include block copolymers of ethylene oxide (EO) and propylene oxide (PO) (diblock copolymers, PEO (polyethylene oxide)-PPO (polypropylene oxide)-PEO triblock copolymers, PPO-PEO-PPO triblock copolymers, etc.), random copolymers of EO and PO, polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene-2-ethylhexylether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octyl phenyl ether, polyoxyethylene nonyl phenyl ether, polyoxyethylene dodecyl phenyl ether, polyoxyethylene styrated phenyl ether, polyoxyethylene laurylamine, polyoxyethylene stearylamine, polyoxyethylene oleylamine, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbit tetraoleate, polyoxyethylene castor oil, polyoxyethylene castor wax, polyoxyethylene methyl glucoside, and polyoxypropylene methyl glucoside. Particularly preferable surfactants include block copolymers of EO and PO (in particular, PEO-PPO-PEO triblock copolymer), random copolymers of EO and PO, and polyoxyethylene alkyl ethers (e.g., polyoxyethylene decyl ether). A preferable polyoxyethylene alkyl ether has about 1 mole to 10 (e.g., about 3 to 8) moles of EO added.

The nonionic surfactant has a molecular weight of below 3000. By using a surfactant with a molecular weight below 3000, defects can be reduced. The low molecular weight of the nonionic surfactant is also preferred in view of filterability and cleanability. In some preferable embodiments, the nonionic surfactant has a molecular weight of, for instance, below 2500, more preferably below 2000, even more preferably 1900 or lower (e.g., below 1800), yet more preferably 1500 or lower, or particularly preferably 1000 or lower (e.g., 500 or lower). In view of surfactant activity, the molecular weight of the nonionic surfactant is typically suitably 200 or higher. In view of haze reduction, it is preferably 250 or higher (e.g., 300 or higher).

The molecular weight of the surfactant can be calculated from its chemical formula, or the weight average molecular weight determined by GPC (aqueous phase, based on standard polyethylene glycols) can be used. The GPC analysis conditions can be the same as those for the water-soluble polymer. For instance, in case of a polyoxyethylene alkyl ether, the molecular weight calculated from its chemical formula is preferably used. In case of an EO/PO block copolymer, the weight average molecular weight determined by GPC is preferably used.

The amount α (wt%) of nonionic surfactant with mw < 3000 in the polishing composition (typically a polishing slurry) is in the range of 0.00035 < α < 0.00500. With α > 0.00035, defects can be reduced. With α < 0.00500, good wettability and defect reduction can be obtained. From such a viewpoint, in some preferable embodiments, α can be 0.00050 or greater, 0.00100 or greater, or 0.00150 or greater. In some preferable embodiments, α is 0.00400 or less, more preferably 0.00300 or less, yet more preferably 0.00250 or less, even more preferably 0.00200 or less, further more preferably 0.00150 or less, particularly preferably 0.00100 or less, or may be 0.00080 or less.

While no particular limitations are imposed, in some embodiments, in view of wettability, defect reduction, cleanability, etc., the amount of nonionic surfactant with mw < 3000 per 100 parts by weight of abrasive (typically, silica particles) is suitably 20 parts by weight or less, or may be 10 parts by weight or less, or 5 parts by weight or less. In view of good combination of wettability and defect reduction, in some embodiments, the nonionic surfactant content per 100 parts by weight of abrasive is 4 parts by weight or less, more preferably 3 parts by weight or less, yet more preferably 2 parts by weight or less, even more preferably 1 part by weight or less (e.g., below 1 part by weight), particularly preferably 0.8 part by weight or less, or may be 0.6 part by weight or less, or 0.5 part by weight or less. For more effective defect reduction, in some embodiments, the surfactant content per 100 parts by weight of abrasive is suitably 0.001 part by weight or greater, or may be 0.01 part by weight or greater, or 0.1 part by weight or greater. In some preferable embodiments, the nonionic surfactant content per 100 parts by weight of abrasive is 0.25 part by weight or greater, more preferably 0.3 part by weight or greater, or yet more preferably 0.4 part by weight or greater.

While no particular limitations are imposed, in some embodiments, the weight ratio (D/C) of the amount (D) of the nonionic surfactant with mw < 3000 to the amount (C) of the VA-VP random copolymer can be, for instance, 0.001 or higher. In view of defect reduction, etc., it is suitably 0.005 or higher, preferably 0.01 or higher, or may be 0.03 or higher, or 0.05 or higher. In view of good defect reduction, in some preferable embodiments, the weight ratio (D/C) is 0.10 or higher, more preferably 0.15 or higher, yet more preferably 0.20 or higher, or may be 0.40 or higher, 0.50 or higher, 0.60 or higher, or 0.70 or higher. In view of wettability, defect reduction, etc., in some embodiments, the weight ratio (D/C) can be, for instance, 10 or lower, or 5 or lower. In view of good combination of wettability and defect reduction, in some preferable embodiments, the ratio (D/C) is 2.0 or lower, preferably 1.0 or lower (e.g., below 1.0), more preferably 0.5 or lower, yet more preferably 0.3 or lower, or may be, for instance, 0.20 or lower.

### <Water>

Preferable examples of the water in the polishing composition disclosed herein include ionexchanged water (deionized water), pure water, ultrapure water, and distilled water. To maximally avoid inhibition of the activities of other components in the polishing composition, for instance, the total amount of transition metal ions in the water used is preferably 100 ppb or less. For example, the water purity can be increased by removal of impurity ions with ion-exchange resin, removal of contaminants with filters, distillation, etc. The polishing composition disclosed herein may further include an organic solvent that can mix uniformly with water (lower alcohol, lower ketone, etc.), as needed. The solvent in the polishing composition is preferably at least 90 vol% (% by volume) water, or more preferably at least 95 vol% water (e.g., 99 vol% to 100 vol%).

### <Optional Water-Soluble Polymer>

While no particular limitations are imposed, to improve surface quality with fewer defects, etc., the polishing composition may optionally include a water-soluble polymer other than the abovementioned VA-VP random copolymer (also referred to as an "optional water-soluble polymer"), or it may be essentially free of such an optional water-soluble polymer. As the optional water-soluble polymer, one, two or more kinds can be used, selected among water-soluble polymers other than VA-VP random copolymers.

The kind of optional water-soluble polymer is not particularly limited. A possible optional water-soluble polymer has at least one functional group selected from cationic, anionic or nonionic groups. The optional water-soluble polymer can have a hydroxy group, a carboxy group, an acyl group, an acyloxy group, a sulfo group, an amide group, a quaternary ammonium structure, a heterocycle structure, a vinyl structure, a polyoxyalkylene structure, etc. Examples of the optional water-soluble polymer include cellulose derivatives; starch derivatives; polymers containing an oxyalkylene unit such as copolymers of ethylene oxide (EO) and propylene oxide (PO); vinyl alcohol-based polymers; N-containing polymers such as polymers having an N-vinyl monomer unit, imine derivatives, and polymers having an N-(meth)acryloyl monomer unit; and polymers having a carboxylic acid (including an acid anhydride). Specific examples include pullulan, random copolymers or block copolymers of ethylene oxide (EO) and propylene oxide (PO), polyglycerol, polyvinyl alcohol (PVA), acetalized polyvinyl alcohol, butene diol polyvinyl alcohol, carboxylated polyvinyl alcohol, sulfonated polyvinyl alcohol, polyvinyl alcohol-polyvinylpyrrolidone graft copolymers, polyvinyl alcohol polyethylene oxide graft copolymers, polyvinyl alcohol polyethylene oxide random copolymers, polyisoprene sulfonic acid, polyvinyl sulfonic acid, polyallyl sulfonic acid, polyisoamylene sulfonic acid, polystyrene sulfonate, polyacrylate, polyvinyl acetate, polyethylene glycol, polyvinyl imidazole, polyvinyl carbazole, polyvinyl pyrrolidone, polyvinyl acetamide, polyacryloylmorpholine, polyhydroxyethyl acrylamide, polyallylamine, glycidol-modified polyallylamine, methyldiallylamine-sulfur dioxide copolymers, polyvinyl caprolactam, polyvinyl piperidine, olefin-maleic acid (anhydride) copolymers, and styrenemaleic acid (anhydride) copolymers. As the optional water-soluble polymer, solely one species or a combination of two or more species can be used. For a simpler composition, the polishing composition disclosed herein may be free of an optional water-soluble polymer.

The Mw of the optional water-soluble polymer is not particularly limited. In some embodiments, in view of concentration efficiency, the optional water-soluble polymer can have a Mw of, for instance, about 200×10⁴ or lower, or about 100×10⁴ or lower, 70×10⁴ or lower, 60×10⁴ or lower, 50×10⁴ or lower, 40×10⁴ or lower, or 30×10⁴ or lower. In view of improving surface quality, in some embodiments, the Mw can be, for instance, 1.0×10⁴ or higher, 5×10⁴ or higher, or 10×10⁴ or higher (e.g., above 10×10⁴). In some embodiments, the Mw is suitably 15×10⁴ or higher, or may be 20×10⁴ or higher, 25×10⁴ or higher, or 30×10⁴ or higher (e.g., above 30×10⁴).

In an embodiment using an optional water-soluble polymer, the amount of optional water-soluble polymer in the polishing composition can be suitably set as long as the effects of this invention are not significantly impaired. The polishing composition disclosed herein can be implemented in an embodiment essentially free of optional water-soluble polymers. From such a viewpoint, in an embodiment where the polishing composition includes an optional water-soluble polymer and in an embodiment essentially free of optional water-soluble polymers, the amount of optional water-soluble polymer in the entire water-soluble polymer content of the polishing composition can be 80 wt% or less, 50 wt% or less (e.g., below 50 wt%), 30 wt% or less, 20 wt% or less, 10 wt% or less, or 5 wt% or less (e.g., 0 to 5 wt%).

### <Optional Surfactant>

While no particular limitations are imposed, as long as the effects of the invention are not significantly impaired, the polishing composition may optionally include a surfactant (optional surfactant) other than the nonionic surfactant with molecular weight below 3000, or may be essentially free of such optional surfactants. Examples of the optional surfactant include a nonionic surfactant having a molecular weight of 3000 or higher, an anionic surfactant, a cationic surfactant, or an amphoteric surfactant. As the optional surfactant, solely one kind or a combination of two or more kinds can be used.

In an embodiment using an optional surfactant, the amount of optional surfactant in the polishing composition can be suitably set as long as the effects of this invention are not significantly impaired. The polishing composition disclosed herein can be implemented in an embodiment essentially free of optional surfactants. From such a viewpoint, in an embodiment where the polishing composition includes an optional surfactant and in an embodiment essentially free of optional water-surfactants, the amount of optional surfactant in the entire surfactant content of the polishing composition can be 50 wt% or less (e.g., below 50 wt%), 30 wt% or less, 20 wt% or less, 10 wt% or less, or 5 wt% or less (e.g., 0 to 5 wt%).

### <Other Components>

As long as the effect of this invention is not significantly impaired, the polishing composition disclosed herein may further include, as necessary, known additives that can be used in polishing compositions (e.g., polishing compositions used in final polishing steps of silicon wafers), such as organic acids, organic acid salts, inorganic acids, inorganic acid salts, chelating agents, antiseptic agents, and antifungal agents.

Among organic and inorganic acids and salts thereof, solely one kind or a combination of two or more kinds can be used. Examples of organic acids include aliphatic acids such as formic acid, acetic acid, and propionic acid; aromatic carboxylic acids such as benzoic acid and phthalic acid; itaconic acid; citric acid; oxalic acid; tartaric acid; malic acid; maleic acid; fumaric acid; succinic acid; glycolic acid; malonic acid; gluconic acid; alanine; glycine; lactic acid; hydroxyethylidene diphosphoric acid (HEDP); organic sulfonic acid such as methanesulfonic acid; nitrilotris(methylenephosphoric acid) (NTMP); and organic phosphonic acid such as phosphonobutane tricarboxylic acid (PBTC). Examples of organic acid salts include alkali metal salts (sodium salts, potassium salts, lithium salts, etc.) and ammonium salts of organic acids. Examples of inorganic acids include hydrochloric acid, phosphoric acid, sulfuric acid, phosphonic acid, nitric acid, phosphinic acid, boric acid, and carbonic acid. Examples of inorganic acid salts include alkali metal salts (sodium salts, potassium salts, lithium salts, etc.) of inorganic acids.

As the chelating agent, solely one kind or a combination of two or more kinds can be used. Examples of the chelating agent include aminocarboxylic acid-based chelating agents and organic phosphonic acid-based chelating agents. Favorable examples of chelating agents include ethylenediamine tetrakis(methylenephosphinic acid), diethylene triamine penta(methylenephosphinic acid), and diethylene triamine pentaacetic acid. Examples of the antiseptic agent and antifungal agent include isothiazoline-based compounds, paraoxybenzoic acid esters, and phenoxyethanol.

The polishing composition disclosed herein is preferably essentially free of an oxidant. This is because when an oxidant-containing polishing composition is supplied to a substrate (e.g., a silicon wafer), it may oxidize the substrate surface and form an oxide layer, thereby reducing the polishing removal rate. Specific examples of the oxidant here include hydrogen peroxide (H₂O₂), sodium persulfate, ammonium persulfate, and sodium dichroloisocyanurate. The polishing composition being essentially free of an oxidant refers to at least no intentional inclusion of an oxidant. Thus, the concept of essentially oxidant-free polishing composition here can include a polishing composition that inevitably includes a trace amount of oxidant (e.g., a molar concentration of an oxidant in polishing composition being 0.001 mol/L or less, preferably 0.0005 mol/L or less, more preferably 0.0001 mol/L or less, yet more preferably 0.00005 mol/L or less, particularly preferably 0.00001 mol/L or less) due to the starting materials, manufacturing process, etc.

### <pH>

The pH of the polishing composition disclosed herein is not particularly limited, and a suitable pH can be selected according to the substrate, etc. In some embodiments, the polishing composition has a pH of suitably 8.0 or higher, preferably 8.5 or higher, more preferably 9.0 or higher. With increasing pH of the polishing composition, the polishing removal rate tends to increase. Meanwhile, in view of preventing dissolution of silica particles and suppressing deterioration of mechanical polishing action, the polishing composition typically has a pH of suitably 12.0 or lower, preferably 11.0 or lower, more preferably 10.8 or lower, or even more preferably 10.5 or lower.

In the art disclosed herein, the pH of a polishing compound can be determined by using a pH meter (e.g., a glass-electrode pH meter (model F-72) available from Horiba, Ltd.). More specifically, in the method used, after three-point calibration using standard buffer solutions (phthalate pH buffer with pH 4.01 (25 °C), neutral phosphate pH buffer with pH 6.86 (25 °C), and carbonate pH buffer with pH 10.01 (25 °C)), the glass electrode is placed in the polishing composition to be measured for at least two minutes; after the pH of the polishing composition has stabilized, the pH is measured.

### <Polishing Slurry>

The polishing composition disclosed herein is typically supplied to the substrate surface as a polishing slurry that includes the polishing composition, and used for polishing the substrate. For instance, the polishing slurry can be prepared by diluting a polishing composition disclosed herein (typically, with water). Alternatively, the polishing composition may be used as is as the polishing slurry. Other examples of the polishing slurry that includes the polishing composition disclosed herein include a polishing slurry obtained by adjusting the pH of the composition.

The amount of abrasive (typically silica particles) in the polishing slurry is not particularly limited. It is, for instance, 0.005 wt% or greater, preferably 0.01 wt% or greater, more preferably 0.03 wt% or greater, yet more preferably 0.05 wt% or greater, or may be 0.08 wt% or greater, or 0.10 wt% or greater (e.g., above 0.10 wt%). With increasing abrasive content, a higher polishing removal rate can be obtained. The abrasive content is suitably 10 wt% or less, preferably 7 wt% or less, more preferably 5 wt% or less, or even more preferably 2 wt% or less, for instance, 1 wt% or less, or may be 0.5 wt% or less, 0.4 wt% or less, or 0.3 wt% or less. This helps maintain surface quality.

The amount of basic compound in the polishing slurry is not particularly limited. In view of increasing the polishing removal rate, etc., in typical, it is suitably 0.0005 wt% or greater, preferably 0.001 wt% or greater, more preferably 0.003 wt% or greater, or yet more preferably 0.005 wt% or greater (e.g., above 0.005 wt%). In view of improving the surface quality (e.g., haze reduction), etc., it is suitably below 0.1 wt%, preferably below 0.05 wt%, or more preferably below 0.03 wt% (e.g., below 0.025 wt%, or even below 0.01 wt%).

In view of increasing the wettability, etc., the VA-VP random copolymer content of the polishing slurry is, for instance, or may be 0.0001 wt% or greater, or typically suitably 0.0005 wt% or greater. In some preferable embodiments, it is 0.001 wt% or greater, or may be, for instance, 0.002 wt% or greater, or 0.0025 wt% or greater. The maximum VA-VP random copolymer content is not particularly limited. For instance, it can be, 0.05 wt% or less. In view of the stability in a concentrated form, polishing removal rate, cleanability, etc., in some embodiments, the VA-VP random copolymer content is preferably 0.03 wt% or less, more preferably 0.015 wt% or less, and even more preferably 0.01 wt% or less. The polishing slurry disclosed herein can be preferably implemented, for instance, in an embodiment where the VA-VP random copolymer content is 0.008 wt% or less, 0.006 wt% or less, or 0.004 wt% or less.

As the amount of nonionic surfactant with a molecular weight below 3000 in the polishing slurry, the abovementioned range of α applies.

### <Concentrated liquid>

The polishing composition disclosed herein may be in a concentrated form (i.e., in the form of a polishing slurry concentrated liquid) before supplied to a substrate. Such concentrated polishing compositions are preferred in view of convenience and cost reduction during production, distribution, storage, etc. The concentration factor is not particularly limited. For instance, it can be about 2-fold to 100-fold in volume, and is usually suitably about 5-fold to 50-fold (e.g., about 10-fold to 40-fold). Such a concentrated liquid can be diluted when desired to prepare a polishing slurry (working slurry), which can then be used by supplying it to a substrate. The dilution can be performed by adding water to the concentrated liquid and mixing them, for instance.

When the polishing composition (i.e., the concentrated liquid) is diluted for use in polishing, the abrasive content of the concentrated liquid can be, for instance, 25 wt% or less. In view of dispersion stability and filterability of the polishing composition, the abrasive content is typically preferably 20 wt% or less, or more preferably 15 wt% or less. In some preferred embodiments, the abrasive content may be 10 wt% or less, or 5 wt% or less. In view of convenience and cost reduction during production, distribution, storage, etc., the abrasive content of the concentrated liquid can be, for instance, 0.1 wt% or greater, and is preferably 0.5 wt% or greater, more preferably 0.7 wt% or greater, or even more preferably 1 wt% or greater (e.g., above 1 wt%).

In some embodiments, the amount of basic compound in the concentrated liquid can be, for instance, less than 15 wt%. In view of storage stability, etc., the basic compound content is typically preferably 10 wt% or less (e.g., below 10 wt%), more preferably 3 wt% or less, or may be 1 wt% or less (e.g., below 1 wt%), or 0.5 wt% or less. In view of convenience and cost reduction during production, distribution, storage, etc., the amount of basic compound in the concentrated liquid can also be, for instance, 0.005 wt% or greater, preferably 0.01 wt% or greater, more preferably 0.05 wt% or greater, or yet more preferably 0.1 wt% or greater.

In some embodiments, the total water-soluble polymer content (which can be the VA-VP random copolymer content) of the concentrated liquid can be, for instance, 3 wt% or less. In view of the filterability and ease of cleaning of the polishing composition, it is typically preferably 1 wt% or less, or more preferably 0.5 wt% or less. In view of convenience and cost reduction during production, distribution, storage, etc., it is typically suitably 0.001 wt% or greater, preferably 0.005 wt% or greater, or more preferably 0.01 wt% or greater.

In some embodiments, the surfactant content (e.g., the amount of nonionic surfactant with mw < 3000) in the concentrated liquid can be, for instance, 0.25 wt% or less, preferably 0.15 wt% or less, more preferably 0.1 wt% or less, or may be 0.05 wt% or less, or 0.025 wt% or less. The surfactant content (e.g., the amount of nonionic surfactant with mw < 3000) in the concentrated liquid can also be, for instance, 0.0001 wt% or greater, preferably 0.001 wt% or greater, more preferably 0.005 wt% or greater, or even more preferably 0.01 wt% or greater.

### <Preparation of Polishing Composition>

The polishing composition used in the art disclosed herein may be a single-agent type or a multi-agent type such as a two-agent type. For instance, the polishing composition may be configured to prepare a polishing slurry by mixing Part A and Part B and diluting the mixture as needed when appropriate, with Part A including at least the abrasive among its components and Part B including at least some of the remaining components.

The method for preparing the polishing composition is not particularly limited. For instance, the respective components of the polishing composition can be mixed, using a known mixing device such as a blade stirrer, ultrasonic disperser, or homomixer. The embodiment of mixing these components is not particularly limited. For instance, all the components may be mixed at once or in a predetermined suitable order.

### <Applications>

The polishing composition disclosed herein is suitable for polishing a surface formed of a silicon material (typically, for polishing a silicon wafer). Specific examples of the silicon material include single silicon crystal, amorphous silicon, and polysilicon. The polishing composition disclosed herein can be particularly preferably used for polishing a surface formed of single silicon crystal (e.g., for polishing a silicon wafer).

The polishing composition disclosed herein can be preferably applied to a step of polishing a substrate (e.g., a silicon wafer). Before the polishing step with the polishing composition disclosed herein, the substrate may be subjected to a general treatment applicable to the substrate in a step upstream of the polishing step, such as lapping or etching.

The polishing composition disclosed herein is effective when used in the final polishing step of a substrate (e.g., a silicon wafer) or in the polishing step immediately preceding it. It is particularly preferable for use in the final polishing step. The final polishing step here refers to the last polishing step (i.e., the step followed by no further polishing) in a manufacturing process of objects of interest. The polishing composition disclosed herein may also be used in a polishing step upstream of the final polishing (the upstream step referring to a stock polishing step between the rough polishing step and the last polishing step, typically including at least a primary polishing step, and may further include a secondary, tertiary, etc. polishing steps). For instance, it can be used in a polishing step performed immediately before final polishing.

The polishing composition disclosed herein is effectively used, for instance, in polishing (typically, final polishing or polishing just before that) a silicon wafer adjusted to a surface roughness of 0.01 nm to 100 nm in an upstream step. It is particularly preferable for final polishing. The surface roughness Ra of a substrate can be measured using, for instance, laser scanning surface roughness meter TMS-3000WRC available from Schmitt Measurement System Inc.

### <Polishing>

The polishing composition disclosed herein can be used for polishing a substrate, for instance, in an embodiment including the following operation. Described next is a preferable embodiment of the method for polishing a silicon wafer as the substrate, using the polishing composition disclosed herein.

In other words, a polishing slurry is obtained, including a polishing composition disclosed herein. Obtaining the polishing slurry may include preparing the polishing slurry by subjecting the polishing composition to concentration adjustment (e.g., dilution), pH adjustment, etc. Alternatively, the polishing composition may be used as is as a polishing slurry.

Subsequently, the polishing slurry is supplied to a substrate, and polishing is carried out by a common method. For example, in final polishing of a silicon wafer, the silicon wafer that has undergone a lapping step is typically set in a general polishing machine, and then the polishing slurry is supplied through the polishing pad of the polishing machine to the silicon wafer surface to be polished. Typically, while the polishing slurry is continuously supplied, the polishing pad is pushed against the silicon wafer surface to be polished and both are moved (rotated) relative to each other. Through such a polishing step, the substrate is completely polished.

The polishing pad used in the polishing step is not particularly limited. The polishing pad can be of, for instance, foamed polyurethane, nonwoven fabric, suede, etc. Each polishing pad may or may not include an abrasive. Usually, abrasive-free polishing pads are preferably used.

The substrate polished with the polishing composition disclosed herein is typically cleaned. Cleaning can be performed using a suitable cleaning solution. The cleaning solution used is not particularly limited. For instance, it is possible to use SC-1 cleaning solution (a mixture of ammonium hydroxide (NH₄OH), hydrogen peroxide (H₂O₂) and water (H₂O)), SC-2 cleaning solution (a mixture of HCl, H₂O₂, and H₂O), ozone water cleaning solution, hydrofluoric acid cleaning solution, etc., which are common in the semiconductor industry. The temperature of the cleaning solution can be within the range of room temperature (typically, about 15 °C to 25 °C) or higher to about 90 °C. In view of improving the cleaning effect, a cleaning solution at about 50 °C to 85 °C can be preferably used.

As mentioned above, the art disclosed herein may also provide a method for producing a polished material, the method including a polishing step (preferably the final polishing) by an aforementioned polishing method (e.g., a method for producing a silicon wafer); and a polished material (e.g., a silicon wafer) produced by the method.

The matters disclosed herein include the following:
(1) A polishing composition used in polishing a surface formed of a silicon material,
   the polishing composition including an abrasive, a basic compound, a random copolymer comprising a vinyl alcohol unit and an N-vinylpyrrolidone unit, and a nonionic surfactant, wherein
   the nonionic surfactant has a molecular weight of below 3000, and
   the nonionic surfactant is contained in an amount α (wt%) in the range of 0.00035 < α < 0.00500.
(2) The polishing composition according to (1) above, wherein a weight ratio of the amount of the nonionic surfactant to the amount of the random copolymer comprising the vinyl alcohol unit and the N-vinylpyrrolidone unit is 0.01 or higher and 2.0 or lower.
(3) The polishing composition according to (1) or (2) above, the polishing composition including silica particles as the abrasive.
(4) A concentrated liquid of the polishing composition according to any of (1) to (3) above.
(5) A polishing method, the method including a step of polishing a surface formed of a silicon material, using the polishing composition according to any of (1) to (4) above.

### [Examples]

Several examples relating to the present invention will be described below, but the present invention is not to be limited to the embodiments shown in the examples. In the following description, "part" and "%" are by weight unless otherwise specified.

### <Preparation of Polishing Composition>

### (Examples 1-3 and Comparative Examples 2-3)

Were mixed an abrasive, a basic compound, a water-soluble polymer, a surfactant, and deionized water to prepare a polishing composition concentrated liquid according to each example. As the abrasive, was used colloidal silica with an average primary particle diameter of 25 nm. As the basic compound, ammonia was used. As the water-soluble polymer, was used a random copolymer having a vinyl alcohol unit and an N-vinylpyrrolidone unit with Mw of about 3.0×10⁴ (poly(VA-r-VP). As the surfactant, was used polyoxyethylene decyl ether (C10EO5) with 5 moles of ethylene oxide added. The resulting polishing composition concentrated liquid was diluted 40-fold by volume with deionized water to obtain a polishing composition (with 0.13 % abrasive, 0.01 % basic compound, 0.003 % poly(VA-r-VP) and the % C10EO5 shown in Table 1) according to each example.

### (Example 4)

As the water-soluble polymer, was used a random copolymer having a vinyl alcohol unit and an N-vinylpyrrolidone unit (poly(VA-r-VP) with Mw of about 3000. Otherwise in the same manner as in Example 2, was prepared a polishing composition according to this example.

### (Comparative Examples 1 and 4-5)

The species of the water-soluble polymer and the surfactant were changed. Otherwise in the same manner as in Example 2, was prepared a polishing composition according to each example. In Table 1, HEC represents hydroxyethyl cellulose, PEO-PPO-PEO represents a PEO-PPO-PEO block copolymer with Mw = 3000, and C12EO18SO3NH4 represents polyoxyethylene lauryl ether ammonium sulfate with 18 moles of ethylene oxide added.

### <Silicon Wafer Polishing>

Under Polishing condition 1, was stock-polished a lapped and etched commercially available silicon single crystal wafer (P-type conductivity, <100> crystal orientation, free of COP (crystal originated particles, i.e., crystal defects)) with a diameter of 300 mm to obtain a silicon wafer as the substrate. The stock polishing was performed using a polishing slurry with 0.6 % abrasive (colloidal silica with an average primary particle diameter of 35 nm) and 0.08 % tetramethylammonium hydroxide (TMAH) in deionized water.

### [Polishing Condition 1]

Polishing machine: a single wafer polishing machine, model PNX-332B, manufactured by Okamoto Machine Tool Works, Ltd.
Polishing pressure: 20 kPa
Platen rotational speed: 20 rpm
Head (carrier) rotational speed: 20 rpm
Polishing pad: product name SUBA400 manufactured by Nitta Dupont Inc.
Supply flow rate of polishing slurry: 1.0 L/min
Polishing slurry temperature: 20 °C
Platen cooling water temperature: 20 °C
Polishing time: 2 min

Using the polishing composition prepared above according to each example as the polishing slurry, the silicon wafer after stock polishing was polished under Polishing condition 2 and consecutively under Polishing condition 3 shown below.

### [Polishing Condition 2]

Polishing machine: a single wafer polishing machine, model PNX-332B, manufactured by Okamoto Machine Tool Works, Ltd.
Polishing pressure: 16 kPa
Platen rotational speed: 52 rpm
Head (carrier) rotational speed: 50 rpm
Polishing pad: product name POLYPAS275NX manufactured by Fujibo Ehime Co., Ltd.
Supply flow rate of polishing slurry: 1.5 L/min
Polishing slurry temperature: 20 °C
Platen cooling water temperature: 20 °C
Polishing time: 2 min

### [Polishing Condition 3]

Polishing machine: a single wafer polishing machine, model PNX-332B, manufactured by Okamoto Machine Tool Works, Ltd.
Polishing pressure: 20 kPa
Platen rotational speed: 52 rpm
Head (carrier) rotational speed: 50 rpm
Polishing pad: product name POLYPAS275NX manufactured by Fujibo Ehime Co., Ltd.
Supply flow rate of polishing slurry: 1.5 L/min
Polishing slurry temperature: 20 °C
Platen cooling water temperature: 20 °C
Polishing time: 2 min

### <Measurement of Water-Repellent Distance>

When unloading the polished silicon wafer, was measured the maximum radial distance (water-repellent distance) (mm) of the water-repellent area from the wafer edges. If the water-repellent distance (mm) was 20 mm or less, it was graded as "Good" (Pass). If the water-repellent distance was more than 20 mm, it was graded as "Poor" (Fail). The results are shown in the corresponding column in Table 1.

### <Cleaning>

The polished silicon wafer removed from the polishing machine was subjected to a total of 15 sets of cleaning processes, with one set consisting of cleaning with an ozone water cleaning solution (60 seconds) using a single wafer cleaning machine followed by cleaning with SC-1 cleaning solution using a brush (110 seconds) followed by cleaning with an ozone water cleaning solution (20 seconds) and cleaning with a hydrofluoric acid cleaning solution (15 seconds); and it was further cleaned with an ozone water cleaning solution (20 seconds), and then dried.

### <LPD-N Analysis>

Using a wafer surface tester (product name SURFSCAN SP5 available from KLA-Tencor Corporation), the number of LPD-N present on the cleaned silicon wafer surface was analyzed in the Oblique mode of the device, and graded based on the following scale.
Good: the number of LPD-N is 100 or fewer
Acceptable: the number of LPD-N is more than 100 and up to 500
Poor: the number of LPD-N is more than 500

Good and Acceptable were graded as Pass, and Poor was graded as Fail. The results are shown in the corresponding column in Table 1.

### [Table 1]

**Table 1**

| | Water-soluble polymer | | | Surfactant | | | | Water repellent distance | | LPD-N |
|---|---|---|---|---|---|---|---|---|---|---|
| | Species | Mw | Concentration (%) | Species | Electrical charge | Mw | Concentration (%) | (mm) | Grade | Grade |
| Ex. 1 | poly(VA-r-VP) | 30,000 | 0.003 | C10EO5 | Nonion | 378 | 0.00036 | 3 | Good | Good |
| Ex. 2 | poly(VA-r-VP) | 30,000 | 0.003 | C10EO5 | Nonion | 378 | 0.00060 | 3 | Good | Good |
| Ex. 3 | poly(VA-r-VP) | 30,000 | 0.003 | C10EO5 | Nonion | 378 | 0.00200 | 7 | Good | Acceptable |
| Ex. 4 | poly(VA-r-VP) | 3,000 | 0.003 | C10EO5 | Nonion | 378 | 0.00060 | 0 | Good | Good |
| Comp. Ex. 1 | HEC | 250,000 | 0.003 | C10EO5 | Nonion | 378 | 0.00060 | 150 | Poor | Poor |
| Comp. Ex. 2 | poly(VA-r-VP) | 30,000 | 0.003 | C10EO5 | Nonion | 378 | 0.00010 | 2 | Good | Poor |
| Comp. Ex. 3 | poly(VA-r-VP) | 30,000 | 0.003 | C10EO5 | Nonion | 378 | 0.01000 | 150 | Poor | Poor |
| Comp. Ex. 4 | poly(VA-r-VP) | 30,000 | 0.003 | PEO-PPO-PEO | Nonion | 3,000 | 0.00060 | 1 | Good | Poor |
| Comp. Ex. 5 | poly(VA-r-VP) | 30,000 | 0.003 | C12EO18SO3NH4 | Anion | 1,000 | 0.00060 | 150 | Poor | Good |

As shown in Table 1, with respect to Examples 1 to 4 using a polishing composition that included an abrasive, a basic compound, a random copolymer having a VA unit and a VP unit, and a nonionic durfactnat with Mw below 3000, in which the nonionic surfactant is contained in an amount of more that 0.00035% and lower than 0.005 %, the water-repellent distance was 20 mm or less and the number of LPD-N was 500 or less, showing good wettability with minor defects. On the other hand, in Comparative Example 1 using HEC as the water-soluble polymer, both wettability and defects were inferior to those of the working examples. In Comparative Example 2 where the amount of the nonionic surfactant was 0.00035 % or less, though the water-repellent distance was small, the number of LPD-N was more than 500. Wettability was not combined with defect reduction in this comparative example. In Comparative Example 3 where the amount of the nonionic surfactant was 0.005 % or more, failing results occurred in both wettability and defects. In Comparative Example 4 using a nonionic surfactant with a molecular weight of 3000, though the water-repellent distance was small, the number of LPD-N was more than 500. Wettability was not combined with defect reduction in this comparative example. In Comparative Example 5 using an anionic surfactant instead of a nonionic surfactant, sufficient wettability was not obtained.

Although specific embodiments of the present invention have been described in detail above, these are merely for illustrations and do not limit the scope of claims. The art according to the claims includes various modifications and changes made to the specific embodiments illustrated above.

## Claims

1. A polishing composition used in polishing a surface formed of a silicon material,
the polishing composition containing an abrasive, a basic compound, a random copolymer comprising a vinyl alcohol unit and an N-vinylpyrrolidone unit, and a nonionic surfactant, wherein
the nonionic surfactant has a molecular weight of below 3000, and
the nonionic surfactant is contained in an amount α (wt%) in the range of 0.00035 < α < 0.00500.

2. The polishing composition according to Claim 1, wherein a weight ratio of the amount of the nonionic surfactant to an amount of the random copolymer comprising the vinyl alcohol unit and the N-vinylpyrrolidone unit is 0.01 or higher and 2.0 or lower.

3. The polishing composition according to Claim 1 or 2, wherein the abrasive comprises silica particles.

4. A concentrated liquid of the polishing composition according to Claim 1 or 2.

5. A polishing method including a step of polishing a surface formed of a silicon material, using the polishing composition according to Claim 1 or 2.
